# EUROPEAN PATENT APPLICATION

(11) **EP 4 550 394 A1**
(43) Date of publication of application: **07.05.2025**
(21) Application number: 24208017.4
(22) Date of filing: 22.10.2024
(51) Int. Cl.: H01L 21/683, H01L 23/544, H01L 25/065, H01L 25/00

(54) **WAFER BONDING METHOD INCLUDING REMOVING TRANSPARENT OR TRANSLUCENT MATERIAL**

(30) Priority: 31.10.2023 US 202363594435 P; 24.04.2024 US 202418644210
(71) Applicant: SAMSUNG ELECTRONICS CO., LTD., Yeongtong-gu Suwon-si, Gyeonggi-do 16677 (KR)
(72) Inventor: KIM, Taesun, San Jose, CA 95134 (US); LEE, Yeojin, San Jose, CA 95134 (US); SEO, Kang-ill, San Jose, CA 95134 (US)
(74) Representative: Kuhnen & Wacker Patent- und Rechtsanwaltsbüro PartG mbB

(57) **Abstract**

Wafer-bonding methods are provided. A wafer-bonding method includes overlaying a first wafer (120) and a second wafer (110) with each other. The first wafer (120) includes a transparent or translucent material (222) having first alignment marks (126) thereon. The second wafer (110) has second alignment marks (214). The method includes providing light through the first wafer (120) to check alignment of the first alignment marks (126)with the second alignment marks (214). The method includes bonding the first wafer (120) to the second wafer (110). Moreover, the method includes removing the transparent or translucent material (222) while the first alignment marks (126) remain bonded to the second wafer (110).

## Description

### TECHNICAL FIELD

The present disclosure generally relates to the field of semiconductor-device fabrication and, more particularly, to wafer-bonding processes.

### BACKGROUND OF THE INVENTION

The size of transistors has continued to decrease to facilitate the scale-down of logic elements. To aid with this scale-down, three-dimensional (3D) device structures and 3D stacking processes have been proposed.

One type of 3D device structure under consideration is a stacked transistor. The stacked transistor may include a first transistor and a second transistor. The first transistor may be a first type of transistor (e.g., an n-type field-effect transistor (nFET)), and the second transistor may be a second type of transistor (e.g., a p-type field-effect transistor (pFET)). The first and second transistors may be stacked in any order (e.g., first on top of second, or second on top of first), resulting in a stacked structure comprising a top device and a bottom device.

Wafer-bonding technology may be used to implement a 3D (e.g., stacked) structure such as a backside power-rail. During a wafer-bonding process, misalignment between two wafers may need to be corrected. Wafer thickness and/or other limitations of conventional alignment processes, however, can make it difficult to correct such misalignment.

### SUMMARY OF THE INVENTION

A wafer-bonding method, according to some embodiments herein, may include overlaying a first wafer and a second wafer with each other. The first wafer may include a transparent or translucent material having first alignment marks thereon. The second wafer may have second alignment marks. The method may include providing light through the first wafer to check alignment of the first alignment marks with the second alignment marks. The method may include bonding the first wafer to the second wafer. Moreover, the method may include removing the transparent or translucent material while the first alignment marks remain bonded to the second wafer.

A wafer-bonding method, according to some embodiments herein, may include providing a first wafer over a second wafer. The first wafer may include a transparent or translucent material having a release material thereon and first alignment marks thereon. The second wafer may include second alignment marks. The method may include providing light through the transparent or translucent material and the release material to check alignment of the first alignment marks with the second alignment marks. The method may include bonding the first wafer to the second wafer, after providing the light through the transparent or translucent material and the release material. Moreover, the method may include removing the transparent or translucent material and the release material while the first alignment marks remain bonded to the second wafer.

A wafer-bonding method, according to some embodiments herein, may include forming a release material on a first wafer that includes a transparent or translucent material. The method may include forming a bonding material on the release material. The method may include etching the bonding material to form first alignment marks. The method may include providing the first wafer over a second wafer. The second wafer may include second alignment marks. The method may include providing light through the transparent or translucent material and the release material to check alignment of the first alignment marks with the second alignment marks. The method may include bonding the first alignment marks to an adhesive layer that is on the second wafer, after providing the light through the transparent or translucent material and the release material. Moreover, the method may include removing the transparent or translucent material and the release material while the first alignment marks remain bonded to the adhesive layer that is on the second wafer.

### BRIEF DESCRIPTION OF THE DRAWINGS

FIG. 1A is a schematic block diagram of a wafer-alignment system according to some embodiments herein.
FIG. 1B is an example top view of the upper wafer of FIG. 1A.
FIG. 1C is an example top view of a die in the upper wafer of FIG. 1B.
FIGs. 2A-2D are cross-sectional views illustrating wafer-bonding operations according to some embodiments herein.
FIGs. 3A-3D are cross-sectional views illustrating operations of forming alignment marks on the upper wafer of FIG. 1A according to some embodiments herein.
FIG. 4 is a flowchart corresponding to the operations shown in FIGs. 2A-2D and 3A-3D.

### DETAILED DESCRIPTION

Pursuant to embodiments herein, wafer-bonding methods are provided that include directly aligning upper alignment marks on an upper wafer with lower alignment marks on a lower wafer. This direct alignment may be facilitated by using an upper wafer that comprises a transparent (or translucent) material, such as quartz or glass. As used herein, the term "direct alignment" refers to using alignment-measuring light (e.g., visible light, infrared (IR) light, or other light) that passes through the transparent (or translucent) upper wafer to reach a lower wafer so that bonding equipment or a human user can determine whether the upper wafer and the lower wafer are aligned based on an overlap image (i.e., an image showing overlap of the wafers) generated while using upper alignment marks and lower alignment marks on the upper wafer and the lower wafer, respectively. For example, bonding equipment or a user may use the overlap image to verify that the upper wafer correctly overlaps the lower wafer, which can be achieved only when the upper alignment marks and the lower alignment marks are properly aligned. Moreover, the bonding equipment or user can adjust (i.e., move) the upper wafer and/or the lower wafer until a single image showing proper overlap is generated.

On the other hand, as used herein, the term "indirect alignment" refers to merely estimating relative locations of the upper alignment marks and the lower alignment marks. For example, the bonding equipment or user may separately capture a first image of the upper alignment marks and a second image of the lower alignment marks. Then, the bonding equipment or user may calculate relative positions of those two images and move the upper wafer and lower wafer to where those images can be aligned. The equipment or user cannot directly see whether the upper and lower alignment marks are actually aligned. Rather, such alignment is estimated (e.g., calculated) using the separate images.

The upper wafer may be a donor (e.g., carrier) wafer that is to be bonded to the lower wafer, and the transparent (or translucent) material of the upper wafer may be removed (e.g., together with a release material) after bonding the wafers together. Moreover, the wafers may facilitate high-order correction of wafer misalignment because the wafers may each include a large number of alignment marks. Because the upper wafer is transparent (or translucent), alignment marks can be located not only outside of a die, but also inside the die. These internal alignment marks of the die allow high-order correction to be performed for better alignment. High-order correction thus compares more alignment marks, and thereby improves alignment precision. High-order correction may use, for example, at least second-order equations (e.g., second to fifth-order equations) to determine whether the alignment is acceptable.

In contrast with direct alignment, conventional indirect-alignment techniques can make it difficult to correct misalignment between wafers. Thick wafers, and/or a relatively-small number of alignment marks, can also increase the difficulty of correcting misalignment when using conventional wafer-bonding processes and equipment. Non-high-order correction that compares the relatively-small number of alignment marks may use, for example, only first-order equations when determining whether alignment is acceptable, and thus may result in lower alignment precision. When using an indirect-alignment technique, only alignment marks on boundaries of dies or outside of dies tend to be useful. As many other alignment marks (e.g., those that are inside a die) may not be detectable when using the indirect-alignment technique, it may not be helpful to attempt to use a large number of alignment marks with the indirect-alignment technique. Even if those alignment marks could be detectable (e.g., visible) when using the indirect-alignment technique, such detectability may not dramatically improve alignment precision, as the indirect-alignment technique would still rely on estimation, which is less precise than direct alignment.

Moreover, whereas some embodiments herein may facilitate easy removal of a transparent (or translucent) material of an upper wafer (after bonding) by removing the transparent (or translucent) material together with a release material, conventional bonding processes may not remove a transparent (or translucent) material of a wafer and/or may not use a release material. According to some embodiments, a bonding material of the upper wafer can be adhered well by using the release material on one side of the bonding material and an adhesive layer (on the lower wafer) on the opposite side of the bonding material. Conventional wafer-bonding processes may lack this combination of a release material and an adhesive layer.

Example embodiments will be described in greater detail with reference to the attached figures.

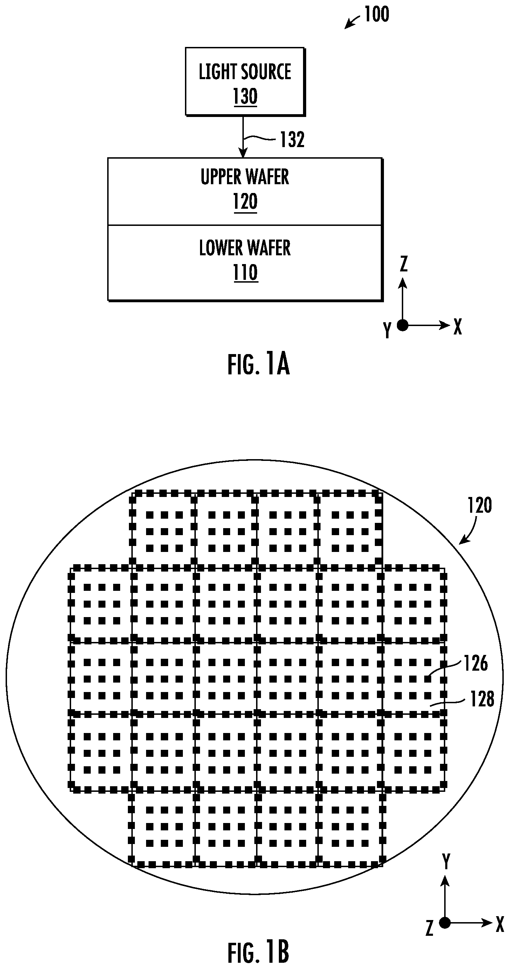

FIG. 1A is a schematic block diagram of a wafer-alignment system 100 according to some embodiments herein. The system 100 includes an alignment light source 130 that is configured to provide light 132 onto (and through) an upper wafer 120 and then onto a lower wafer 110 to help align the wafers 110, 120. For example, the light source 130 may comprise a laser light source, and the light 132 may comprise a laser beam. In some embodiments, the light 132 may comprise visible light. In other embodiments, the light 132 may comprise invisible light, such as IR light.

The light source 130 is used to provide the light 132 onto the wafers 110, 120 while the wafer 120 overlaps the wafer 110 in a vertical direction Z. For example, the light source 130 may be configured to provide the light 132 downward in the direction Z onto the wafers 110, 120. The direction Z is perpendicular to horizontal directions X, Y.

In some embodiments, the light source 130 may be part of bonding equipment that is used to bond the wafers 110, 120 to each other. In other embodiments, the light source 130 may be separate from the bonding equipment. For simplicity of illustration, the bonding equipment is omitted from view in FIG. 1A.

The system 100 may also include wafer-handling equipment (e.g., a wafer-handling robot) that is configured to move and/or provide mechanical support for the wafers 110, 120 while bonding/aligning the wafers 110, 120. For simplicity of illustration, however, wafer-handling equipment is omitted from view in FIG. 1A. In some embodiments, the wafer-handling equipment may be part of bonding equipment. Moreover, the system 100 may include one or more additional light sources, and/or may include equipment (e.g., bonding equipment) that applies heat to the wafers 110, 120. The additional light source(s) and equipment that applies heat, however, are omitted from view in FIG. 1A for simplicity of illustration.

FIG. 1B is an example top view of the upper wafer 120. As shown in FIG. 1B, the wafer 120 includes several dies 128, each of which comprises several alignment marks 126. For example, the wafer 120 may comprise at least five rows (in the direction X) and at least four columns (in the direction Y) of dies 128, and an inner/main region of each die 128 may comprise at least three rows and at least three columns of alignment marks 126. Accordingly, the alignment marks 126 may be in an array comprising at least fifteen rows and at least twelve columns on the wafer 120. The wafer 120 may thus comprise at least 180 alignment marks 126. As an example, the wafer 120 (e.g., all of the inner/main regions of the dies 128) may comprise at least 234 alignment marks 126.

Moreover, a perimeter region of each die 128 may comprise, for example, twenty alignment marks 126, some of which may be shared with neighboring dies 128. Accordingly, when the wafer 120 is transparent or translucent (i.e., for direct alignment), each die 128 may comprise a total of about 25-30 (e.g., at least 25) alignment marks 126. Including both perimeter alignment marks 126 and inner alignment marks 126, the wafer 120 may comprise at least 500 alignment marks 126. In some embodiments, the wafer 120 may comprise more than 540 alignment marks 126, or even more than 1,000 alignment marks 126. For example, when the wafer 120 includes many (e.g., 60 or more) dies 128, the wafer 120 may comprise about 1,800-2,000 alignment marks 126. The large number of alignment marks 126, which are facilitated by using a transparent or translucent material of the wafer 120 for direct alignment, can help to improve alignment precision.

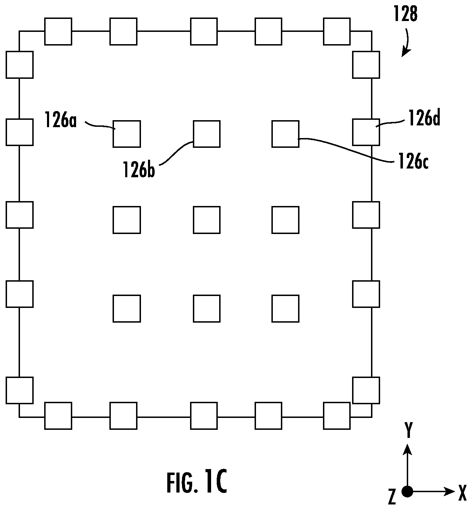

FIG. 1C is an example top view of a die 128 in the upper wafer 120 (FIG. 1B). As shown in FIG. 1C, an inner/main region of the die 128 comprises a first column of alignment marks 126a, a second column of alignment marks 126b, and a third column of alignment marks 126c. In some embodiments, each column may comprise three alignment marks 126. The inner/main region of the die 128 may thus comprise nine alignment marks 126. Moreover, each perimeter edge of the die 128 may comprise five alignment marks 126d. The perimeter of the die 128 may thus comprise twenty alignment marks 126d, and the die 128 may comprise a total of 29 alignment marks 126.

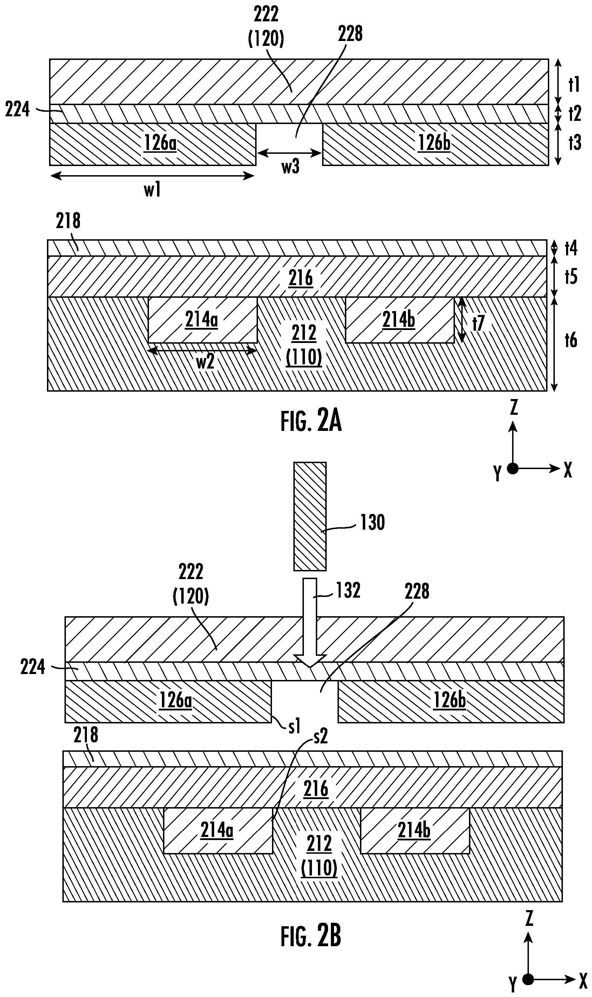

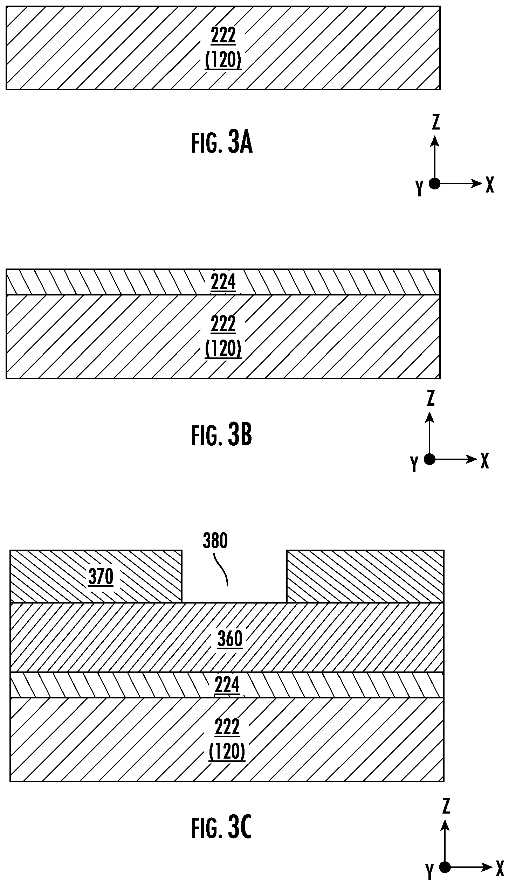

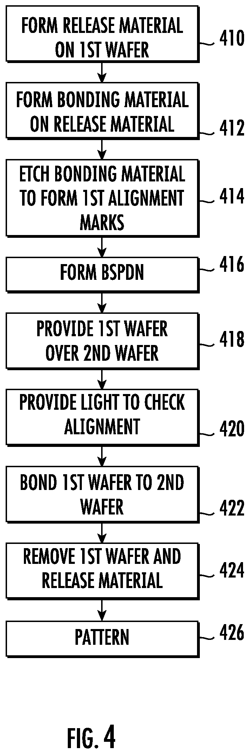

FIGs. 2A-2D are cross-sectional views illustrating wafer-bonding operations according to some embodiments herein. FIGs. 3A-3D are cross-sectional views illustrating operations of forming alignment marks 126 on the upper wafer 120 (FIG. 1A) according to some embodiments herein. FIG. 4 is a flowchart corresponding to the operations shown in FIGs. 2A-2D and 3A-3D.

As shown in FIGs. 2A and 4, wafer-bonding operations may include overlaying (Block 418) an upper wafer 120 and a lower wafer 110 with each other. As used herein, the phrase "overlaying a [first/upper] wafer and a [second/lower] wafer with each other" may refer to either (a) providing the upper wafer 120 over the lower wafer 110 or (b) providing the lower wafer 110 over the upper wafer 120. The wafer 120 may comprise a transparent (or translucent) material 222 that has a plurality of alignment marks 126 thereon. For example, the transparent (or translucent) material 222 may comprise glass or quartz and may have a pair of alignment marks 126a, 126b thereon that are spaced apart from each other in the direction X by a gap 228 having a width w3.

The wafer 110 has a plurality of alignment marks 214. In some embodiments, the alignment marks 214 may be in a main material/layer 212 of the wafer 110. For example, the main material/layer 212 may comprise a semiconductor layer, and uppermost surfaces of a pair of alignment marks 214a, 214b may be coplanar with an uppermost surface of the semiconductor layer.

For simplicity of illustration, only two alignment marks 126 and two alignment marks 214 are shown in FIG. 2A. As described with respect to FIG. 1B, however, the wafer 120 may have a large total number of (e.g., hundreds of) alignment marks 126 thereon. Similarly, the wafer 110 may have hundreds of alignment marks 214. According to some embodiments, the wafer 110 may have the same number of alignment marks as the wafer 120. The wafer 120 can thus be aligned with the wafer 110 by comparing (and matching) alignment marks 126 of the wafer 120 with alignment marks 214 of the wafer 110.

In some embodiments, a size of the alignment marks 126 of the wafer 120 may be different from a size of the alignment marks 214 of the wafer 110. For example, the alignment marks 126 may each have a width w1 that is wider, in the direction X, than a width w2 of each alignment mark 214. The alignment marks 126 of the wafer 120 may thus be referred to herein as "wide" alignment marks, and the alignment marks 214 of the wafer 110 may be referred to herein as "narrow" alignment marks. In other embodiments, however, the alignment marks 126 of the wafer 120 may have the same width as the alignment marks 214 of the wafer 110. Moreover, the width w3 of the gap 228 may, according to some embodiments, be narrower than the width w2 of the alignment marks 214.

The wafers 110, 120 may have different thicknesses. As an example, the main material/layer 212 of the wafer 110 may have a thickness t6 that is thicker, in the direction Z, than a thickness t1 of the transparent (or translucent) material 222 of the wafer 120. Because the transparent (or translucent) material 222 is both transparent (or translucent) and relatively thin, it can facilitate providing light 132 (FIG. 2B) therethrough to check alignment of the wafers 110, 120.

The alignment marks 126 may have a thickness t3, and the alignment marks 214 may have a thickness t7. In some embodiments, the thickness t3 of the alignment marks 126 may be the same as the thickness t7 of the alignment marks 214, which is thinner than the thickness t6 of the main material/layer 212 of the wafer 110. According to some embodiments, the thickness t3 of the alignment marks 126 may be thinner than the thickness t1 of the transparent (or translucent) material 222 of the wafer 120. In other embodiments, the thickness t3 of the alignment marks 216 may equal the thickness t1 of the transparent (or translucent) material 222 of the wafer 120.

A release material 224 may be between, in the direction Z, the transparent (or translucent) material 222 and the alignment marks 126. For example, a first surface of the release material 224 may contact the transparent (or translucent) material 222, and an opposite, second surface of the release material 224 may contact the alignment marks 126. The release material 224 is used in a subsequent operation to separate the wafer 120 from the wafer 110. The release material 224 may have a thickness t2 that is thinner, in the direction Z, than each of the thicknesses 11, t3. The release material 224 may thus be thinner than the transparent (or translucent) material 222 and thinner than the alignment marks 126. The thinner the release material 224, the more cost and size can be reduced for the operations shown in FIGs. 2A-2D. Moreover, the release material 224 may comprise, for example, a material that is temperature-sensitive and/or ultraviolet (UV) light-sensitive, as a subsequent thermal and/or UV process may be used to separate the release material 224 from the wafer 110 after bonding the wafers 110, 120 together. According to some embodiments, the release material 224 may comprise an amorphous fluoro-polymer material, fluorinated alkylchlorosilane, or a silane coupling agent.

A bonding oxide 216 may be on the alignment marks 214 and the main material/layer 212 of the wafer 110. A thickness t5 of the bonding oxide 216 may be thinner, in the direction Z, than the thickness t6 of the main material/layer 212 of the wafer 110. The bonding oxide 216 may comprise, for example, an oxide (e.g., silicon oxide or silicon oxynitride) or silicon nitride.

An adhesive layer 218 may be on the bonding oxide 216, which is between the adhesive layer 218 and the alignment marks 214. As an example, an upper surface of the bonding oxide 216 may contact a lower surface of the adhesive layer 218. A lower surface of the bonding oxide 216 may contact upper surfaces of the alignment marks 214 and/or an upper surface of the main material/layer 212 of the wafer 110. The adhesive layer 218 is used in a subsequent operation to bond the wafers 110, 120 to each other. A thickness t4 of the adhesive layer 218 may be thinner, in the direction Z, than the thicknesses t5, t7 of the bonding oxide 216 and the alignment marks 214. The adhesive layer 218 may thus be thinner than the bonding oxide 216 and thinner than the alignment marks 214. The thinner the adhesive layer 218, the more cost and size can be reduced for the operations shown in FIGs. 2A-2D. In some embodiments, the thickness t4 of the adhesive layer 218 may be thinner than the thickness t2 of the release material 224. In other embodiments, the thickness t4 of the adhesive layer 218 may equal the thickness t2 of the release material 224. Moreover, the adhesive layer 218 may comprise, for example, a temperature-sensitive and/or UV-light-sensitive material, such as benzocyclobutene (BCB) or a UV-sensitive epoxy resin. In some embodiments, the adhesive layer 218 may comprise methacryloxypropyltrichlorosilane.

As shown in FIGs. 2B and 4, light 132 from the light source 130 may be provided (Block 420) through the transparent (or translucent) material 222 to check (e.g., compare/verify) alignment of the alignment marks 126 with the alignment marks 214. For example, the light 132 may be used to check alignment of the alignment mark 126a with the alignment mark 214a. As an example, the light 132 may be used to check alignment of a sidewall S1 of the alignment mark 126a with a sidewall S2 of the alignment mark 214a. As the alignment mark 126a may be wider than the alignment mark 214a, a second sidewall of the alignment mark 126a that is opposite the sidewall S1 the alignment mark 126a may not be aligned with a second sidewall of the alignment mark 214a that is opposite the sidewall S2 the alignment mark 214a. Rather, an inner/middle portion of the alignment mark 126a may vertically overlap the second sidewall of the alignment mark 214a.

In some embodiments, the light 132 may also be used to check alignment of the alignment mark 126b (e.g., a sidewall thereof) with the alignment mark 214b (e.g., a sidewall thereof). The light 132 may pass through the transparent (or translucent) material 222, then pass through the release material 224, and next pass through the gap 228 that is between the alignment marks 126a, 126b. Subsequently, the light 132 may pass between the alignment marks 214a, 214b of the wafer 110.

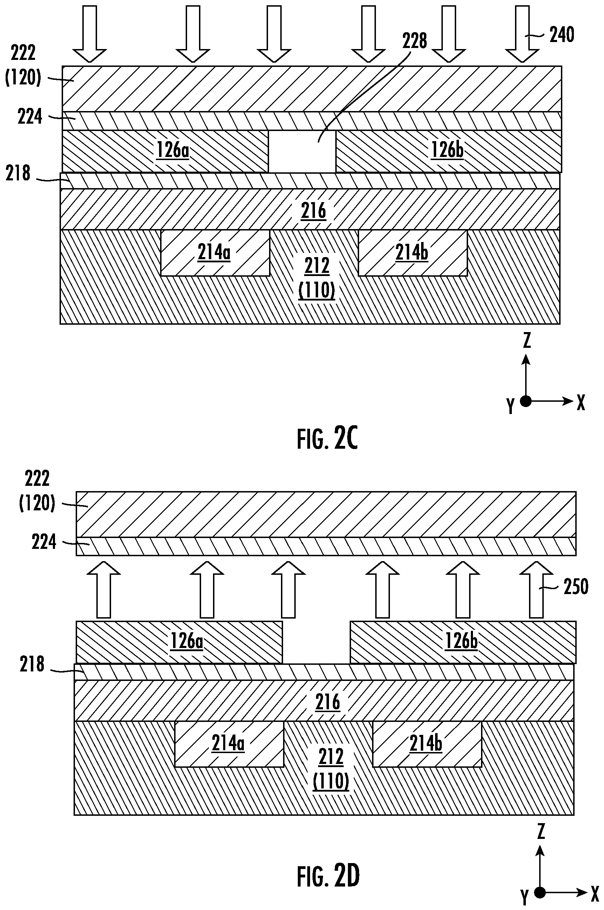

As shown in FIGs. 2C and 4, the wafer 120 may be bonded (Block 422) to the wafer 110, after providing the light 132 (FIG. 2B) through the transparent (or translucent) material 222. As an example, the wafers 110, 120 may be bonded by applying a thermal (i.e., heat) and/or light treatment 240 to the wafers 110, 120. According to some embodiments, the thermal/light treatment 240 may apply a temperature of 25 °C to 150 °C to bond the wafers 110, 120. The thermal/light treatment 240 may help the adhesive layer 218 on the wafer 110 to bond with the alignment marks 126 on the wafer 120. For example, the alignment marks 126 may contact (and be bonded with) an upper surface of the adhesive layer 218. Moreover, the alignment marks 126 may comprise a bonding material such as an oxide, silicon nitride, silicon oxynitride, silicon, germanium, or silicon germanium. In some embodiments, the thermal/light treatment 240 may comprise UV light. The UV light may be provided by, for example, the light source 130 or another light source.

In some embodiments, the alignment marks 126 may be at the same vertical level, in the direction Z, as at least a portion of a backside power delivery network (BSPDN), which may include components such as backside power-rails. Accordingly, operation(s) of bonding the wafers 110, 120 together may include bonding the BSPDN (or a portion thereof) to the wafer 110. For simplicity of illustration, however, the BSPDN is omitted from view in FIG. 2C.

As shown in FIGs. 2D and 4, the transparent (or translucent) material 222 may be removed (Block 424) from the alignment marks 126 while the alignment marks 126 remain bonded to the wafer 110 (e.g., bonded to the adhesive layer 218 that is on the wafer 110). According to some embodiments, the release material 224 may be removed along with (i.e., together with) the transparent (or translucent) material 222. For example, FIG. 2D shows an operation 250 of releasing (e.g., lifting) both the transparent (or translucent) material 222 and the release material 224 upward in the direction Z.

The release material 224 may be removed by providing UV light to the release material 224. As an example, the UV light may be provided by the light source 130 or another light source to the release material 224 through the transparent (or translucent) material 222. UV light may be less likely than heat to deform the wafer 110. Accordingly, using UV light to remove the release material 224 may help to reduce/prevent wafer deformation. To distinguish the UV light from the light 132 (FIG. 2B) that is used to check wafer alignment, the light 132 and the UV light may be referred to herein as "first" light and "second" light, respectively.

After removing the release material 224, wafer patterning (Block 426) may be performed. For example, patterning may be performed on the wafer 110. As an example, the wafer 110 may be rotated 180 degrees, and patterning may be performed to form circuit elements on a first side of the wafer 110 that is opposite a second side of the wafer 110 that has the alignment marks 214 therein/thereon. The release material 224 thus facilitates easy removal of the transparent (or translucent) material 222 so that the structure previously underlying the transparent (or translucent) material 222 can be patterned. Moreover, before removing the release material 224 (and after bonding the wafers 110, 120), a portion of the release material 224 that is exposed through the gap 228 (FIG. 2C) may face an exposed portion of the adhesive layer 218 through the gap 228.

Though the adhesive layer 218 and the release material 224 are both shown in FIGs. 2C and 2D, they may, in some embodiments, be omitted. For example, using a particular gas, catalyst, and/or atmosphere, it may be possible to bond the wafers 110, 120 without using the adhesive layer 218, and/or to separate the wafers 110, 120 without using the release material 224. Accordingly, under certain gas, catalyst, and/or atmosphere conditions, (i) the adhesive layer 218, (ii) the release material 224, or (iii) both the adhesive layer 218 and the release material 224 may be omitted.

As shown in FIGs. 3A-3D and 4, before providing the wafer 120 over the wafer 110 (and thus before checking alignment of the wafers 110, 120), alignment marks 126 are formed on the wafer 120. Referring to FIG. 3A, the transparent (or translucent) material 222 is provided. Referring to FIGs. 3B and 4, the release material 224 is formed (Block 410) on the transparent (or translucent) material 222. As an example, the release material 224 may be deposited on the transparent (or translucent) material 222.

Referring to FIGs. 3C and 4, a bonding material 360 is formed (Block 412) on the release material 224. Moreover, a mask layer 370 may be formed on the bonding material 360, and may be patterned to have an opening 380 that exposes a portion of the bonding material 360. The mask layer 370 may have an etch selectivity relative to the bonding material 360 and may be patterned by, for example, photo patterning (e.g., photolithography).

The bonding material 360 may be deposited on the release material 224, and may comprise a material that is configured to limit/reduce stress to the wafer 110. For example, in some embodiments, the bonding material 360 may be a tensile-stress material. In other embodiments, the bonding material 360 may be a compressive-stress material. Examples of the bonding material 360 include an oxide or silicon nitride (or silicon oxynitride). Other examples include silicon, germanium, or silicon germanium.

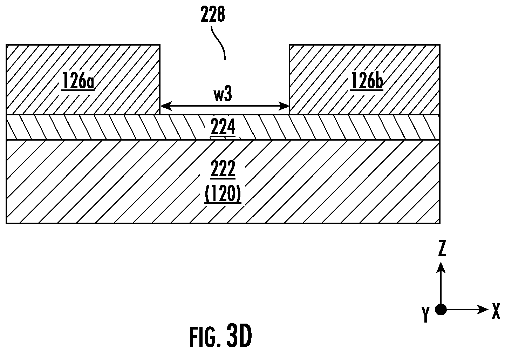

Referring to FIGs. 3D and 4, the exposed portion of the bonding material 360 is etched (Block 414) to form alignment marks 126a, 126b having a gap 228 therebetween. According to some embodiments, etching the bonding material 360 may include exposing a portion of the release material 224 through the gap 228.

For simplicity of illustration, FIGs. 3C and 3D show the formation of only two alignment marks 126. It will be understood, however, that the mask layer 370 may be patterned to have a large number (e.g., hundreds) of openings 380 therein, and that etching of the bonding material 360 may be performed through each of the openings 380 to form respective gaps 228 in the bonding material 360. As a result, a large number of (e.g., hundreds of, or even more than 1,000) alignment marks 126 may be formed from the bonding material 360. Moreover, referring to FIGs. 2A and 3D, the wafer 120 may be rotated 180 degrees so that the alignment marks 126 face the wafer 110 before checking alignment of the wafers 110, 120.

A BSPDN (or a portion thereof) may be formed on the wafer 120 at the same vertical level as the alignment marks 126. In some embodiments, the BSPDN may be formed (Block 416) on the release material 224 after forming the alignment marks 126. In other embodiments, the BSPDN may be formed on the release material 224 before forming the alignment marks 126. For simplicity of illustration, however, the BSPDN is omitted from views in FIGs. 3B-3D.

Wafer-bonding methods according to embodiments herein may provide a number of advantages. These advantages include providing enhanced direct alignment of an upper wafer 120 to a lower wafer 110 by using a transparent (or translucent) material 222 (FIG. 2B) for the wafer 120. The transparent (or translucent) material 222 can facilitate checking for alignment of the wafers 110, 120 before they are bonded together, and thus can make it easier to detect and correct misalignment. Moreover, the wafer 120 may have a large number (e.g., hundreds) of alignment marks 126 (FIG. 1B) thereon, which may facilitate high-order correction of misalignment between the wafers 110, 120 before they are bonded together. The alignment marks 126 may be directly aligned with alignment marks 214 (FIG. 2B) of the wafer 110. Also, the alignment marks 126 comprise a bonding material 360 (FIG. 3C) that can adhere well to an adhesive layer 218 that is on the wafer 110.

When the wafers 110, 120 are bonded together, a release material 224 may be between the transparent (or translucent) material 222 of the wafer 120 and the alignment marks 126. The transparent (or translucent) material 222 can thus be easily removed by removing the release material 224.

Example embodiments are described herein with reference to the accompanying drawings. Many different forms and embodiments are possible without deviating from the teachings of this disclosure and so the disclosure should not be construed as limited to the example embodiments set forth herein. Rather, these example embodiments are provided so that this disclosure will be thorough and complete, and will convey the scope of the present invention to those skilled in the art. In the drawings, the sizes and relative sizes of layers and regions may be exaggerated for clarity. Like reference numbers refer to like elements throughout.

Example embodiments are described herein with reference to cross-sectional illustrations that are schematic illustrations of idealized embodiments and intermediate structures of example embodiments. As such, variations from the shapes of the illustrations as a result, for example, of manufacturing techniques and/or tolerances, are to be expected. Thus, embodiments herein should not be construed as limited to the particular shapes illustrated herein but may include deviations in shapes that result, for example, from manufacturing.

It should also be noted that in some alternate implementations, the functions/acts noted in flowchart blocks herein may occur out of the order noted in the flowcharts. For example, two blocks shown in succession may in fact be executed substantially concurrently or the blocks may sometimes be executed in the reverse order, depending upon the functionality/acts involved. Moreover, the functionality of a given block of the flowcharts and/or block diagrams may be separated into multiple blocks and/or the functionality of two or more blocks of the flowcharts and/or block diagrams may be at least partially integrated. Finally, other blocks may be added/inserted between the blocks that are illustrated, and/or blocks/operations may be omitted without departing from the scope of the present invention.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly-formal sense unless expressly so defined herein.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including," when used in this specification, specify the presence of the stated features, steps, operations, elements, and/or components, but do not preclude the presence or addition of one or more other features, steps, operations, elements, components, and/or groups thereof.

It will be understood that when an element is referred to as being "coupled," "connected," or "responsive" to, or "on," another element, it can be directly coupled, connected, or responsive to, or on, the other element, or intervening elements may also be present. In contrast, when an element is referred to as being "directly coupled," "directly connected," or "directly responsive" to, or "directly on," another element, there are no intervening elements present. As used herein, the term "and/or" includes any and all combinations of one or more of the associated listed items. Moreover, the symbol "/" (e.g., when used in the term "source/drain") will be understood to be equivalent to the term "and/or."

It will be understood that although the terms "first," "second," etc. may be used herein to describe various elements, these elements should not be limited by these terms. These terms are only used to distinguish one element from another. Thus, a first element could be termed a second element without departing from the teachings of the present embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if a device in the figures is turned over, elements described as "below" or "beneath" other elements or features would then be oriented "above" the other elements or features. Thus, the term "below" can encompass both an orientation of above and below. The device may be otherwise oriented (e.g., rotated 90 degrees or at other orientations) and the spatially relative descriptors used herein may be interpreted accordingly.

Many different embodiments have been disclosed herein, in connection with the above description and the drawings. It will be understood that it would be unduly repetitious and obfuscating to literally describe and illustrate every combination and subcombination of these embodiments. Accordingly, the present specification, including the drawings, shall be construed to constitute a complete written description of all combinations and subcombinations of the embodiments described herein, and of the manner and process of making and using them, and shall support claims to any such combination or subcombination.

## Claims

1. A wafer-bonding method comprising:
overlaying a first wafer (120) and a second wafer (110) with each other, wherein the first wafer (120) comprises a transparent or translucent material (222) having first alignment marks (126) thereon, and wherein the second wafer (110) comprises second alignment marks (214);
providing light (132) through the first wafer (120) to check alignment of the first alignment marks (126) with the second alignment marks (214);
bonding the first wafer (120) to the second wafer (110); and
removing the transparent or translucent material (222) while the first alignment marks (126) remain bonded to the second wafer (110).

2. The wafer-bonding method of Claim 1, wherein providing the light (132) comprises providing the light (132) through a release material (224) that is between the transparent or translucent material (222) and the first alignment marks (126).

3. The wafer-bonding method of Claim 2, wherein the release material (224) is removed along with the transparent or translucent material (222).

4. The wafer-bonding method of Claim 3,
wherein the light (132) comprises first light, and
wherein second light comprising ultraviolet light is used to remove the release material (224).

5. The wafer-bonding method of any one of Claims 2 to 4, wherein the release material (224) is thinner than the transparent or translucent material (222) and thinner than the first alignment marks (126).

6. The wafer-bonding method of any one of Claims 1 to 5, wherein the transparent or translucent material (224) comprises glass or quartz

7. The wafer-bonding method of Claim 1,
wherein the first alignment marks (126) comprise a wide alignment mark,
wherein the second alignment marks (214) comprise a narrow alignment mark that is narrower than the wide alignment mark, and
wherein providing the light (132) comprises checking whether a sidewall (s1) of the wide alignment mark is aligned with a sidewall (s2) of the narrow alignment mark.

8. The wafer-bonding method of Claim 1, further comprising forming the first alignment marks (126) on the first wafer (120), before overlaying the first wafer (120) and the second wafer (110) with each other, wherein forming the first alignment marks (126) comprises:
forming a release material (224) on the transparent or translucent material (222);
forming a bonding material (360) on the release material (224); and
etching the bonding material (360) to form the first alignment marks (126) and expose a portion of the release material (224).

9. The wafer-bonding method of Claim 8, wherein bonding the first wafer (120) to the second wafer (110) comprises bonding the first alignment marks (126) to an adhesive layer (218) that is on the second wafer (110).

10. The wafer-bonding method of Claim 9, wherein the exposed portion of the release material (224) faces an exposed portion of the adhesive layer (218) through a gap between the first alignment marks (126), after bonding the first wafer (120) to the second wafer (110) and before removing the transparent or translucent material (222).

11. The wafer-bonding method of Claim 9 or 10,
wherein a bonding oxide (216) is between the adhesive layer (218) and the second alignment marks (214), and
wherein the adhesive layer (218) is thinner than the bonding oxide (216) and thinner than the second alignment marks (214).

12. The wafer-bonding method of any one of Claims 1 to 11, further comprising forming a backside power delivery network, BSPDN, at least a portion of which is at the same vertical level as the first alignment marks (126).

13. The wafer-bonding method of Claim 3 to 5, wherein:
bonding the first wafer (120) to the second wafer (110) is performed after providing the light through the transparent or translucent material (222) and the release material (224).

14. The wafer-bonding method of Claim 13, further comprising forming the first alignment marks on the first wafer (120), before overlaying the first wafer (120) and the second wafer (110) with each other, wherein forming the first alignment marks (126) comprises:
forming the release material (224) on the transparent or translucent material (222);
forming a bonding material (360) on the release material (224); and
etching the bonding material (360) to form the first alignment marks (126) and expose a portion of the release material (224).

15. The wafer-bonding method of Claim 14,
wherein the method further comprises forming at least a portion of a backside power delivery network, BSPDN, on the release material (224),
wherein bonding the first wafer to the second wafer (110) comprises bonding the first alignment marks (126) to an adhesive layer (218) that is on the second wafer (110), and
wherein the exposed portion of the release material (224) faces an exposed portion of the adhesive layer (218) through a gap between the first alignment marks (126), after bonding the first wafer (120) to the second wafer (110) and before removing the transparent or translucent material (222).
